# EUROPEAN PATENT APPLICATION

(11) **EP 4 424 749 A1**
(43) Date of publication of application: **04.09.2024**
(21) Application number: 22886862.6
(22) Date of filing: 20.10.2022
(51) Int. Cl.: C08G 73/10, C09J 179/08, H05K 1/03

(54) **POLYAMIC ACID VARNISH, POLYIMIDE COMPOSITION, AND ADHESIVE**

(30) Priority: 27.10.2021 JP 2021175481
(71) Applicant: Mitsui Chemicals, Inc., Tokyo 104-0028 (JP)
(72) Inventor: TAKASE, Ko, Sodegaura-shi, Chiba 299-0265 (JP); OKAZAKI, Masaki, Sodegaura-shi, Chiba 299-0265 (JP); TSUKADA, Yuichi, Sodegaura-shi, Chiba 299-0265 (JP)
(74) Representative: Hoffmann Eitle
(86) International application number: PCT/JP2022/039166
(87) International publication number: WO 2023/074534

(57) **Abstract**

A polyamic acid varnish according to the present disclosure contains a polyamic acid. The monomers that constitute this polyamic acid include: a monomer (A) that has a C4-12 linear alkylene group but does not have an ester bond, an amide bond, or an ether bond; and a monomer (B) that is a monomer other than the monomer (A). The monomer (A) content is 15 to 70 mol% with respect to the total amount of the monomers that constitute the polyamic acid. The monomer (B) contains at least 90 mol% aromatic monomer.

## Description

### Technical Field

The present disclosure relates to a polyamic acid varnish, a polyimide composition, and an adhesive.

### Background Art

Conventionally, adhesives used for electronic circuit boards, semiconductor devices, and the like are typically epoxy resins. However, epoxy resins do not have sufficient heat resistance or flexibility, and require a long time for thermosetting reaction.

On the other hand, thermoplastic polyimides are known not only to have high heat resistance and flexibility, but also to only require a relatively short time for thermosetting reaction. The use of varnishes and films containing a thermoplastic polyimide is thus under consideration.

For example, a method that dries a coating film of a varnish in which a polyimide is dissolved in a solvent (solvent-soluble polyimide varnish) is proposed (for example, Patent Literatures (hereinafter, referred to as PTLs) 1 to 3). PTL 1 discloses a solvent-soluble polyimide obtained by reacting an acid dianhydride component containing benzophenone tetracarboxylic dianhydride with a diamine component containing a specific siloxane compound. PTL 2 discloses a solvent-soluble polyimide obtained by reacting an acid dianhydride component containing benzophenone tetracarboxylic dianhydride with a diamine component containing a compound having a specific sulfonic acid skeleton. PTL 3 discloses a polyimide resin composition containing an aromatic tetracarboxylic dianhydride having a benzophenone skeleton and aromatic diamine.

### Citation List

### Patent Literature

PTL 1
   Japanese Patent Application Laid-Open No. H9-255780
PTL 2
   Japanese Patent Application Laid-Open No. 2001-310336
PTL 3
   WO2013/008437

### Summary of Invention

### Technical Problem

In the manufacturing process of electronic circuit boards, semiconductor devices, and the like, it is preferred that after applying a thermoplastic polyimide film as an adhesive, the thermoplastic polyimide film can be peeled off without leaving any adhesive residue. The peeling methods include laser lift-off (LLO), mechanical peeling, and dissolving and removing a film with a solvent, but from the viewpoint of easy peeling at low cost, it is required that the film can be dissolved and removed with a solvent or the like.

However, the films obtained from the polyimide varnishes of PLTs 1 and 2 do not have sufficient solubility (re-solubility) in a solvent after the varnish is made into a film. The polyimide composition of PTL 3 is also required to further improve the re-solubility of the film.

In addition, in the manufacturing process of electronic circuit boards, semiconductor devices, and the like, heating steps such as electrode film formation and rewiring processes are necessary; thus, a thermoplastic polyimide film used in the processes is required to have high heat resistance so as not to decompose even at high temperatures.

The present disclosure has been made under the above circumstances, and an object of the present disclosure is to provide a polyamic acid varnish that allows provision of a polyimide having high heat resistance and re-solubility. Another object of the present disclosure is to provide a polyimide composition and an adhesive obtained from the polyamic acid varnish.

### Solution to Problem

The present disclosure relates to a polyamic acid varnish, a polyimide composition, and an adhesive as follows.

<1> A polyamic acid varnish containing a polyamic acid, in which a monomer constituting the polyamic acid contains a monomer (A) that has a linear alkylene group having 4 to 12 carbon atoms and has no ester bond, amide bond, and ether bond, and a monomer (B) other than the monomer (A); and a content of the monomer (A) is 15 to 70 mol% based on a total amount of the monomer constituting the polyamic acid; and the monomer (B) contains 90 mol% or more of an aromatic monomer.
<2> The polyamic acid varnish according to <1>, in which the monomer (A) contains a tetracarboxylic dianhydride (A1) having an aromatic ring; and the aromatic ring is directly bonded with the linear alkylene group and with an acid anhydride group of the tetracarboxylic dianhydride (A1).
<3> The polyamic acid varnish according to <2>, in which the tetracarboxylic dianhydride (A1) is a compound represented by the following Formula (1): 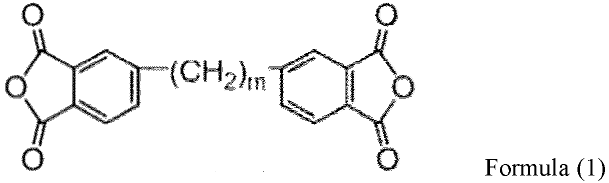 where m is an integer from 4 to 12.
<4> The polyamic acid varnish according to any one of <1> to <3>, in which the aromatic monomer contains at least one aromatic tetracarboxylic dianhydride (B1) selected from the group consisting of an aromatic tetracarboxylic dianhydride having a biphenyl skeleton, an aromatic tetracarboxylic dianhydride having a diphenyl ether skeleton, an aromatic tetracarboxylic dianhydride having a benzophenone skeleton, an aromatic tetracarboxylic dianhydride having a hexafluoroisopropylidene skeleton, and an aromatic tetracarboxylic dianhydride having a fluorene skeleton.
<5> The polyamic acid varnish according to <4>, in which the polyamic acid varnish contains 10 mol% or more of the aromatic tetracarboxylic dianhydride having the biphenyl skeleton based on a total amount of a tetracarboxylic dianhydride constituting the polyamic acid.
<6> The polyamic acid varnish according to any one of <1> to <5>, in which the aromatic monomer contains an aromatic diamine (B2) having a diphenyl ether skeleton.
<7> The polyamic acid varnish according to <6>, in which the aromatic diamine (B2) having the diphenyl ether skeleton has three or more aromatic rings.
<8> The polyamic acid varnish according to <6> or <7>, in which the aromatic diamine (B2) having the diphenyl ether skeleton is represented by the following Formula (2): 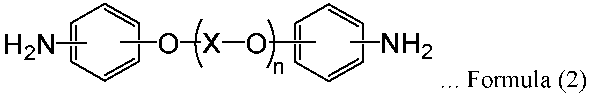 in Formula (2),
   X represents an arylene group having 6 to 10 carbon atoms or a group represented by the following Formula (α), and
   n is an integer from 1 to 3 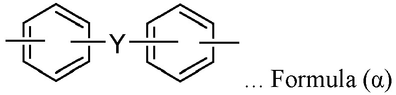
   in Formula (α),
      Y represents a divalent group selected from the group consisting of oxygen atom, sulfur atom, sulfone group, methylene group, fluorene structure, -CR¹R²- (R¹ and R² are each a substituted or unsubstituted alkyl group having 1 to 3 carbon atoms or a phenyl group), and
      R¹ and R² are optionally bonded with each other to form a ring.
<9> The polyamic acid varnish according to any one of <6> to <8>, in which the aromatic diamine (B2) having the diphenyl ether skeleton contains at least one member selected from the group consisting of 1,3-bis(3-aminophenoxy)benzene, 1,3-bis(4-aminophenoxy)benzene, and 2,2-bis[4-(4-aminophenoxy)phenyl]propane.
<10> The polyamic acid varnish according to any one of <1> to <9>, in which a molar ratio between a diamine and a tetracarboxylic dianhydride both constituting the polyamic acid is 0.9 to 0.999, the molar ratio being represented by diamine / tetracarboxylic dianhydride.
<11> The polyamic acid varnish according to any one of <1> to <10>, in which a dissolution ratio represented by the following equation is 50% or more, dissolution ratio (%) = [1-[(weight of filter paper after filtration and drying)- (weight of filter paper before use)]/(weight of film before immersion)]×100, the dissolution ratio being measured after immersing a polyimide film having a size of 2.0 cm × 2.0 cm and a thickness of 20 µm in N-methyl-2-pyrrolidone at 80°C for 3 minutes and then performing filtering through filter paper, the polyimide film being obtained by imidizing the polyamic acid varnish.
<12> The polyamic acid varnish according to any one of <1> to <11>, in which a 5% weight loss temperature of a polyimide film in an atmosphere is 400°C or higher, the polyimide film being obtained by imidizing the polyamic acid varnish.
<13> The polyamic acid varnish according to any one of <1> to <12>, in which an elongation percentage at 23°C of a polyimide film having a thickness of 20 µm is 65% or more, the polyimide film being obtained by imidizing the polyamic acid varnish.
<14> A polyimide composition containing a polyimide, in which a monomer constituting the polyimide contains a monomer (A) that has a linear alkylene group having 4 to 12 carbon atoms and has no ester bond, amide bond, and ether bond, and a monomer (B) other than the monomer (A); a content of the monomer (A) is 15 to 70 mol% based on a total amount of the monomer constituting the polyimide; and the monomer (B) contains 90 mol% or more of an aromatic monomer.
<15> The polyimide composition according to <14>, in which the monomer (A) contains a tetracarboxylic dianhydride (A1) having an aromatic ring; and the aromatic ring is directly bonded with the linear alkylene group and with an acid anhydride group of the tetracarboxylic dianhydride (A1).
<16> The polyimide composition according to <15>, in which the tetracarboxylic dianhydride (A1) is a compound represented by the following Formula (1): 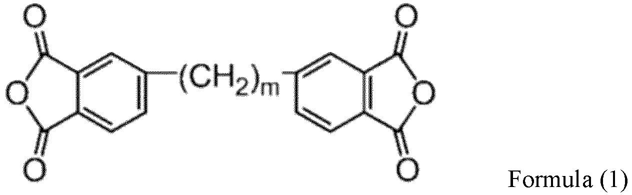 where m is an integer from 4 to 12.
<17> The polyimide composition according to any one of <14> to <16>, in which the aromatic monomer contains at least one aromatic tetracarboxylic dianhydride (B1) selected from the group consisting of an aromatic tetracarboxylic dianhydride having a biphenyl skeleton, an aromatic tetracarboxylic dianhydride having a diphenyl ether skeleton, an aromatic tetracarboxylic dianhydride having a benzophenone skeleton, an aromatic tetracarboxylic dianhydride having a hexafluoroisopropylidene skeleton, and an aromatic tetracarboxylic dianhydride having a fluorene skeleton.
<18> The polyimide composition according to <17>, in which the polyimide composition contains 10 mol% or more of the aromatic tetracarboxylic dianhydride having the biphenyl skeleton based on a total amount of a tetracarboxylic dianhydride constituting the polyimide.
<19> The polyimide composition according to any one of <14> to <18>, in which the aromatic monomer contains an aromatic diamine (B2) having a diphenyl ether skeleton.
<20> The polyimide composition according to <19>, in which the aromatic diamine (B2) having the diphenyl ether skeleton has three or more aromatic rings.
<21> The polyimide composition according to <19> or <20>, in which the aromatic diamine (B2) having the diphenyl ether skeleton is represented by the following Formula (2): 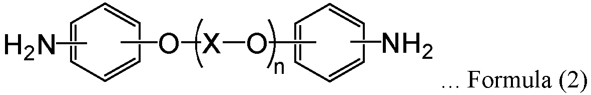 in Formula (2),
   X represents an arylene group having 6 to 10 carbon atoms or a group represented by the following Formula (α), and
   n is an integer from 1 to 3: 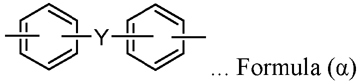
   in Formula (α),
      Y represents a divalent group selected from the group consisting of oxygen atom, sulfur atom, sulfone group, methylene group, fluorene structure, -CR¹R²- (R¹ and R² are each a substituted or unsubstituted alkyl group having 1 to 3 carbon atoms or a phenyl group), and
      R¹ and R² are optionally bonded with each other to form a ring.
<22> The polyimide composition according to any one of <19> to <21>, in which the aromatic diamine (B2) having the diphenyl ether skeleton contains at least one member selected from the group consisting of 1,3-bis(3-aminophenoxy)benzene, 1,3-bis(4-aminophenoxy)benzene, and 2,2-bis[4-(4-aminophenoxy)phenyl]propane.
<23> The polyimide composition according to any one of <14> to <22>, in which a molar ratio between a diamine and a tetracarboxylic dianhydride both constituting the polyimide composition is 0.9 to 0.999, the molar ratio being represented by diamine / tetracarboxylic dianhydride.
<24> The polyimide composition according to any one of <14> to <23>, in which a dissolution ratio represented by the following equation is 50% or more, dissolution ratio (%) = [1 - [(weight of filter paper after filtration and drying) - (weight of filter paper before use)] / (weight of film before immersion)] × 100 the dissolution ratio being measured after immersing the polyimide composition in N-methyl-2-pyrrolidone at 80°C for 3 minutes and then performing filtering through filter paper.
<25> The polyimide composition according to any one of <14> to <24>, in which a 5% weight loss temperature of the polyimide composition in an atmosphere is 400°C or higher.
<26> The polyimide composition according to any one of <14> to <25>, in which an elongation percentage at 23°C of the polyimide composition is 65% or more.
<27> An adhesive, containing the polyimide composition according to any one of <14> to <26>.
<28> The adhesive according to <27>, in which the adhesive is an adhesive for a semiconductor component, an adhesive for a flexible printed circuit board, an adhesive for a coverlay film, or an adhesive for a bonding sheet.

### Advantageous Effects of Invention

The present disclosure is capable of providing a polyamic acid varnish that allows provision of a polyimide having high heat resistance and re-solubility. The present disclosure is also capable of providing a polyimide composition and an adhesive each including the polyamic acid varnish.

### Brief Description of Drawing

FIG. 1 schematically illustrates a test piece to be used in a tensile fracture test; and
FIGS. 2A to 2H are schematic cross-sectional views illustrating an exemplary process of processing of a silicon substrate by using the polyimide composition of the present disclosure as a temporary fixing adhesive.

### Description of Embodiments

Herein, a numerical range expressed using "to" or "-" refers to a range that includes the numerical values written immediately before and after "to" or "-" as the lower limit and upper limit, respectively. In numerical ranges described stepwise herein, the upper or lower limit value described in a certain numerical range may be replaced with the upper or lower limit value of another numerical range in the ranges described stepwise.

In general, polyimides having high heat resistance have a rigid structure thus is difficult to dissolve in a solvent and tends to have low re-solubility. In other words, it is usually difficult to achieve both heat resistance and re-solubility. For the above problem, the present inventors have found that a polyimide that can achieve both high heat resistance (particularly T_{d5}) and re-solubility can be obtained by using the following monomers constituting a polyamic acid-the monomers containing a certain proportion or more of "a monomer (A) that has a linear alkylene group and does not have an ester bond, an amide bond, or an ether bond."

Although not clear, the mechanism can be deduced as follows.

An ester bond, an amide bond, and an ether bond tend to become starting points for thermal decomposition. Monomers that do not have such a bond are less likely to thermally decompose thus can increase the heat resistance (particularly T_{d5}) of the obtained polyimide. In addition, an unbranched linear alkylene group is less likely to thermally decompose and has a flexible structure thus can increase the re-solubility of the obtained polyimide. A polyimide obtained by using such a monomer (A) can have both high heat resistance (particularly T_{d5}) and re-solubility. Hereinafter, the configuration of the polyamic acid varnish of the present disclosure will be explained.

### 1. Polyamic Acid Varnish

A polyamic acid varnish of the present disclosure contains a polyamic acid.

### 1-1. Polyamic acid

The monomer constituting the polyamic acid contains a monomer (A) and a monomer (B).

### (Monomer (A))

The monomer (A) is a monomer that has a linear alkylene group having 4 to 20 carbon atoms and has no ester bond, amide bond, and ether bond, preferably is a monomer that has a linear alkylene group having 4 to 12 carbon atoms and has no ester bond, amide bond, and ether bond. Such a monomer (A) has a flexible structure derived from a linear alkylene group, but does not have a group that is easily decomposed by heat, such as an ester bond, an amide bond, or an ether bond. As a result, the heat resistance and re-solubility of the obtained polyimide can be increased.

Herein, the linear alkylene group having 4 to 12 carbon atoms is a group represented by -CₙH₂ₙ- (n is an integer of 4 to 12) and does not contain an ester bond, an amide bond, an ether bond, or the like. In addition, the linear alkylene group refers to a linear alkylene group that does not have a branched structure (does not have a side chain alkyl group). Alkylene groups that have a branched structure are more likely to thermally decompose, but linear alkylene groups that do not have such a structure are less likely to thermally decompose. The ester bond in this case does not include an ester bond constituting an acid anhydride group.

Such a monomer (A) may be a tetracarboxylic dianhydride or a diamine.

The tetracarboxylic dianhydride is preferably a tetracarboxylic dianhydride (A1) having an aromatic ring. The aromatic ring is preferably a benzene ring. In addition, it is preferred that the aromatic ring is directly bonded with the linear alkylene group, and the aromatic ring is directly bonded with the acid anhydride group. Such a tetracarboxylic dianhydride (A1) has a strong bond between the aromatic ring and the linear alkylene group, and a strong bond between the aromatic ring and the acid anhydride group, and thus is less likely to thermally decompose. Therefore, the heat resistance (particularly T_{d5}) of the obtained polyimide is more likely to increase. Examples of the tetracarboxylic dianhydride (A1) include compounds represented by the following Formula (1), and a compound represented by the Formula below the Formula (1) (BSPA8: 5,5'-(octane-1,8-diyl)bis(isobenzofuran-1,3-dione)). 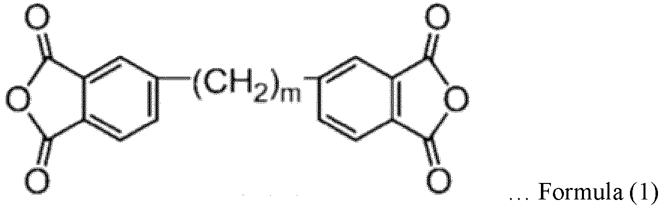 In Formula (1), m is an integer from 4 to 12.

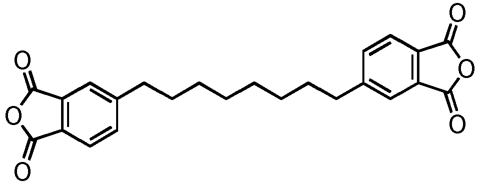

The diamine is preferably an aliphatic diamine (A2) having no aromatic ring. The aliphatic diamine (A2) is preferably an alkylene diamine having a linear alkylene group having 4 to 12 carbon atoms (linear alkylene diamine). Examples of the aliphatic diamine (A2) include 1,6-diaminohexane, 1,7-diaminoheptane, 1,8-diaminooctane, 1,9-diaminononane, 1,10-diaminodecane, 1,11-diaminoundecane, and 1,12-diaminododecane.

In particular, from the viewpoint of easily increasing the heat resistance and re-solubility of the obtained polyimide, the monomer (A) preferably contains the above-described tetracarboxylic dianhydride (A1) (that is, an aromatic tetracarboxylic dianhydride in which an aromatic ring is directly bonded with a linear alkylene group, and the aromatic ring is directly bonded with an acid anhydride group). The monomer (A) more preferably contains a compound represented by Formula (1), and even more preferably contains 5,5'-(octane-1,8-diyl)bis(isobenzofuran-1,3-dione) (BSPA8).

The content of the monomer (A) is preferably 15 to 70 mol% based on the total amount of monomers constituting the polyamic acid (total amount of the tetracarboxylic dianhydride and diamine). When the content of the monomer (A) is 15 mol% or more, the heat resistance of the polyimide film obtained from the polyamic acid varnish can be maintained and the re-solubility of the polyimide film can be increased. When the content of monomer (A) is 70 mol% or less, lowering of the molecular weight during preparation of the polyamic acid varnish can be prevented or minimized. In addition, prevention of a significant decrease in the glass transition temperature of the obtained polyimide film is also possible. From the same viewpoint, the content of the monomer (A) is more preferably 25 to 60 mol%, and even more preferably 35 to 45 mol%, based on the total amount of monomers constituting the polyamic acid.

### (Monomer (B))

The monomer (B) is a monomer other than monomer (A), and contains an aromatic monomer.

The aromatic monomer contained in the monomer (B) is an aromatic monomer that does not have a linear alkylene group, and can increase the heat resistance of the polyimide. The aromatic monomer may be an aromatic tetracarboxylic dianhydride or an aromatic diamine.

The aromatic tetracarboxylic dianhydride is not limited, but preferably contains at least one aromatic tetracarboxylic dianhydride (B1) selected from the group consisting of aromatic tetracarboxylic dianhydrides having a biphenyl skeleton, aromatic tetracarboxylic dianhydrides having a diphenyl ether skeleton, aromatic tetracarboxylic dianhydrides having a benzophenone skeleton, aromatic tetracarboxylic dianhydrides having a hexafluoroisopropylidene skeleton, and aromatic tetracarboxylic dianhydrides having a fluorene skeleton. These aromatic tetracarboxylic dianhydrides (B1) have appropriate rigidity, and thus is more likely to increase the heat resistance (particularly Tas) of the obtained polyimide.

Examples of the aromatic tetracarboxylic dianhydrides having a biphenyl skeleton include 3,3',4,4'-biphenyltetracarboxylic dianhydride, 1,2,1',2'-biphenyltetracarboxylic dianhydride, 2,3,2',3'-biphenyltetracarboxylic dianhydride, and 1,2,2',3-biphenyltetracarboxylic dianhydride.

Examples of the aromatic tetracarboxylic dianhydrides having a diphenyl ether skeleton include 4,4'-(4,4'-isopropylidenediphenoxy)bisphthalic anhydride, 1,3-bis(3,4-dicarboxyphenoxy)benzene dianhydride, 1,4-bis(3,4-dicarboxyphenoxy)benzene dianhydride, 4,4'-oxydiphthalic anhydride, 3,4'-oxydiphthalic anhydride, and 3,3'-oxydiphthalic anhydride. These may be used individually or in combination. In particular, From the viewpoint of availability, 4,4'-oxydiphthalic anhydride is more preferred.

Examples of the aromatic tetracarboxylic dianhydrides having a benzophenone skeleton include 3,3',4,4'-benzophenonetetracarboxylic dianhydride, 2,3,3',4'-benzophenonetetracarboxylic dianhydride, and 2,2',3,3'-benzophenonetetracarboxylic dianhydride.

Examples of the aromatic tetracarboxylic dianhydrides having a hexafluoroisopropylidene skeleton include 2,2-bis(2,3-dicarboxyphenyl)-1,1,1,3,3,3-hexafluoropropane dianhydride (6FDA) and 2,2-bis(3,4-dicarboxyphenyl)-1,1,1,3,3,3-hexafluoropropane dianhydride.

Examples of the aromatic tetracarboxylic dianhydrides having a fluorene skeleton include 9,9-bis(3,4-dicarboxyphenyl)fluorene dianhydride (BPAF).

In particular, from the viewpoint of not having a bond that is easily decomposed by heat and further increasing heat resistance, the aromatic tetracarboxylic dianhydride (B1) more preferably contains an aromatic tetracarboxylic dianhydride having a biphenyl skeleton.

The aromatic tetracarboxylic dianhydride may further contain at least one additional aromatic tetracarboxylic dianhydride other than the above-described aromatic tetracarboxylic dianhydride. Examples of the additional aromatic tetracarboxylic dianhydride include pyromellitic dianhydride, bis(3,4-dicarboxyphenyl) sulfide dianhydride, bis(3,4-dicarboxyphenyl) sulfone dianhydride, bis(3,4-dicarboxyphenyl) methane dianhydride, 2,2-bis(3,4-dicarboxyphenyl) propane dianhydride, 4,4'-bis(3,4-dicarboxyphenoxy) biphenyl dianhydride, 2,3,6,7-naphthalenetetracarboxylic dianhydride, 1,4,5,8-naphthalenetetracarboxylic dianhydride 2,2-bis(2,3-dicarboxyphenyl) propane dianhydride, bis(2,3-dicarboxyphenyl) ether dianhydride, bis(2,3-dicarboxyphenyl) sulfide dianhydride, bis(2,3-dicarboxyphenyl)sulfone dianhydride, and 1,2,5,6-naphthalenetetracarboxylic dianhydride.

At least one or all of the hydrogen atoms on the aromatic ring contained in the aromatic tetracarboxylic dianhydride may be substituted with at least one member selected from fluoro group, methyl group, methoxy group, trifluoromethyl group, and trifluoromethoxy group.

The aromatic diamine preferably contains an aromatic diamine (B2) having a diphenyl ether skeleton. This is because the heat resistance and flexibility of the obtained polyimide can be increased in a well-balanced manner.

The aromatic diamine (B2) having a diphenyl ether skeleton preferably has three or more aromatic rings. Examples of such a aromatic diamine (B2) having a diphenyl ether skeleton include a compound represented by the following Formula (2).

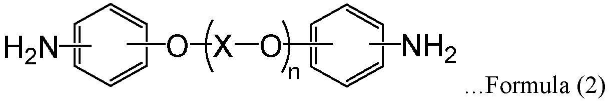

In Formula (2), X represents an arylene group having 6 to 10 carbon atoms or a group represented by Formula (α) below. The bonding positions of the plurality of X's may be the same or different. In addition, at least one hydrogen atom in at least one aromatic ring among the plurality of X may be substituted with an alkyl group or the like. In Formula (2), n is an integer from 1 to 3.

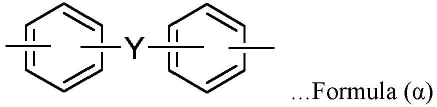

In Formula (α), Y represents a divalent group selected from the group consisting of oxygen atom, sulfur atom, sulfone group, methylene group, fluorene structure, -CR¹R²- (R¹ and R² are each a substituted or unsubstituted alkyl group having 1 to 3 carbon atoms or a phenyl group).

Examples of the alkyl group having 1 to 3 carbon atoms as R¹ or R² include methyl group, ethyl group, propyl group, and trifluoropropyl group. For example, -CR¹R²- may be an isopropylidene group or a hexafluoroisopropylidene group. R¹ and R² may be bonded with each other to form a ring. Examples of the ring formed from R¹ and R² bonded with each other may include cyclohexane ring and cyclopentane ring, and further, an aromatic ring such as a benzene ring may be fused to the ring. Such a linking group has a structure that spreads three-dimensionally, and thus is more likely to increase the re-solubility of the obtained polyimide.

Examples of compounds represented by Formula (2) include the following:
bis[4-(3-aminophenoxy)phenyl]methane, bis[4-(4-aminophenoxy)phenyl]methane, 2,2-bis[4-(3-aminophenoxy)phenyl]propane, 2,2-bis[4-(4-aminophenoxy)phenyl]propane, 2,2-bis[3-(3-aminophenoxy)phenyl]-1,1,1,3,3,3-hexafluoropropane, 2,2-bis[4-(4-aminophenoxy)phenyl]-1,1,1,3,3,3-hexafluoropropane, bis[4-(4-aminophenoxy)phenyl] sulfide, bis[4-(3-aminophenoxy)phenyl]sulfoxide, bis[4-(aminophenoxy)phenyl]sulfoxide, bis[4-(3-aminophenoxy)phenyl]sulfone, bis[4-(4-aminophenoxy)phenyl]sulfone, diamines represented by the following Formulas, 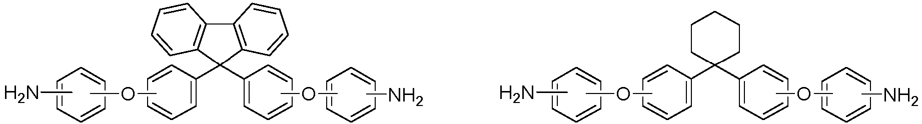
1,3-bis(3-aminophenoxy)benzene, 1,3-bis(4-aminophenoxy)benzene, 1,3-bis(3-(3-aminophenoxy)phenoxy)benzene, 1,3-bis(3-(4-aminophenoxy)phenoxy)benzene, 1,3-bis(4-(3 -aminophenoxy)phenoxy)benzene, 1,3 -bis(3 -(3 -aminophenoxy)phenoxy)-2-methylbenzene, 1,3-bis(3-(4-aminophenoxy)phenoxy)-4-methylbenzene, 1,3-bis(4-(3-aminophenoxy)phenoxy)-2-ethylbenzene, 1,3-bis(3-(2-aminophenoxy)phenoxy)-5-sec-butylbenzene, 1,3-bis(4-(3-aminophenoxy)phenoxy)-2,5-dimethylbenzene, 1,3-bis(4-(2-amino-6-methylphenoxy)phenoxy)benzene, 1,3-bis(2-(2-amino-6-ethylphenoxy)phenoxy)benzene, 1,3-bis(2-(3-aminophenoxy)-4-methylphenoxy)benzene, 1,3-bis(2-(4-aminophenoxy)-4-tert-butylphenoxy)benzene, 1,4-bis(3-(3-aminophenoxy)phenoxy)-2,5-di-tert-butylbenzene, 1,4-bis(3-(4-aminophenoxy)phenoxy)-2,3 -dimethylbenzene, 1,4-bis(3-(2-amino-3-propylphenoxy)phenoxy)benzene, 1,2-bis(3-(3-aminophenoxy)phenoxy)-4-methylbenzene, 1,2-bis(3-(4-aminophenoxy)phenoxy)-3-n-butylbenzene, 1,2-bis(3-(2-amino-3-propylphenoxy)phenoxy)benzene, and 4,4'-bis(4-aminophenyl)-1,4-diisopropylbenzene.

In particular, the aromatic diamine having a diphenyl ether skeleton preferably contains at least one member selected from the group consisting of 1,3-bis(3-aminophenoxy)benzene, 1,3-bis(4-aminophenoxy)benzene, and 2,2-bis[4-(4-aminophenoxy)phenyl]propane. This is because a polyimide with a suitable balance between heat resistance and flexibility can be obtained. In particular, the aromatic diamine having a diphenyl ether skeleton more preferably contains 2,2-bis[4-(4-aminophenoxy)phenyl]propane. This is because all of the aromatic ring bonds are at the para position; thus, greater contribution to flexibility can be expected.

The content of the aromatic monomer is preferably 90 mol% or more, and may be 100 mol%, based on the total amount of the monomer (B). When the content of the aromatic monomer is 90 mol% or more, the heat resistance of the obtained polyimide can be increased.

The monomer (B) may further contain at least one additional monomer other than the above-described aromatic monomer. The additional monomer may be a tetracarboxylic dianhydride or a diamine, but is preferably an alicyclic diamine.

Examples of the alicyclic diamine include 1,2-cyclohexanediamine, 1,3-cyclohexanediamine, 1,4-cyclohexanediamine, 1,4-bis(aminomethyl)cyclohexane, 1,3-bis(aminomethyl)cyclohexane, diaminobicycloheptane, diaminomethyl bicycloheptane (including norbornanediamines, such as norbornanediamine), diaminooxy bicycloheptane, diaminomethyloxy bicycloheptane (including oxanorbornanediamine), and bis(aminocyclohexyl)methane [or methylenebis(cyclohexylamine)]. In particular, norbornane diamine, 1,2-cyclohexanediamine, 1,3-cyclohexanediamine, and 1,4-cyclohexanediamine are preferred because these compounds can increase heat resistance without significantly reducing flexibility.

### (Composition and physical properties)

The monomer composition of the polyamic acid is not limited as long as the composition satisfies the above configuration, but preferably satisfies the following: the monomers constituting the polyamic acid preferably contain a tetracarboxylic dianhydride (A1) as the monomer (A) and an aromatic diamine (B2) having a diphenyl ether skeleton as an aromatic monomer of the monomer (B); and more preferably, the monomers further contain an aromatic tetracarboxylic dianhydride (B1) as the aromatic monomer. More preferably, the aromatic tetracarboxylic dianhydride (B1) contains an aromatic tetracarboxylic dianhydride having a biphenyl skeleton.

Specifically, the content of the tetracarboxylic dianhydride (A1) is preferably 30 mol% or more based on the total amount of tetracarboxylic dianhydride. When the content of the tetracarboxylic dianhydride (A1) is 30 mol% or more, the heat resistance (particularly Tas) and re-solubility of the obtained polyimide is more likely to further increase. From the same viewpoint, the content of the tetracarboxylic dianhydride (A1) is more preferably 40 to 90 mol% based on the total amount of the tetracarboxylic dianhydride.

The content of the aromatic tetracarboxylic dianhydride (B1), preferably the aromatic tetracarboxylic dianhydride having a biphenyl skeleton, is 10 mol% or more based on the total amount of the tetracarboxylic dianhydride. When the content of the aromatic tetracarboxylic dianhydride (B1) is 10 mol% or more, a high molecular weight product is more likely to be obtained, and thus formation of a film becomes easier. The upper limit of the content is not limited, but is preferably, for example, 70 mol% or less. From the same viewpoint, the content of the aromatic tetracarboxylic dianhydride is more preferably 10 to 60 mol% based on the total amount of the tetracarboxylic dianhydride.

The content of the aromatic diamine (B2) having a diphenyl ether skeleton, preferably the aromatic diamine having a diphenyl ether skeleton that has three or more aromatic rings, is preferably 10 mol% or more based on the total amount of diamine. When the content of the diamine is 10 mol% or more, the flexibility of the obtained polyimide is more likely to be increased while the heat resistance of the obtained polyimide is maintained, thereby more likely to increase re-solubility. From the same viewpoint, the content of the aromatic diamine (B2) is preferably 50 mol% or more, more preferably 70 mol% or more, and particularly preferably 80 mol% or more, based on the total amount of the diamine. The upper limit of the content of the aromatic diamine is not limited, but may be, for example, 99 mol% or less, or 98 mol% or less. That is, the content is preferably 10 to 100 mol%, more preferably 10 to 99 mol%. In particular, from the viewpoint of maintaining heat resistance, the content is preferably 80 to 100 mol%, more preferably 80 to 99 mol%.

The composition of a polyamic acid can be identified, for example, by hydrolyzing the polyamic acid with an alkali and performing NMR analysis on the separated components.

The molecular end of the polyamic acid may be either an acid anhydride group or an amino group, but from the viewpoint of increasing re-solubility, an acid anhydride group is preferred. Using a tetracarboxylic dianhydride component (a mol) to be reacted with a diamine component at an amount more than that of the diamine component (b mol) allows the polyamic acid to have an acid anhydride group at the molecular end thereof. Specifically, the molar ratio between the diamine (b mol) and the tetracarboxylic dianhydride (a mol)-both constituting the polyamic acid-is not limited, but preferably the ratio b/a is 0.9 to 0.999, more preferably 0.95 to 0.995, even more preferably 0.97 to 0.995. When the ratio b/a is 0.999 or less, the obtained polyimide is more likely to have an acid anhydride group at the molecular end thereof, and therefore re-solubility is more likely to be obtained. The ratio b/a can be specified as the charging ratio between the tetracarboxylic dianhydride component (a mol) and the diamine component (b mol).

The intrinsic viscosity η of the polyamic acid is preferably 0.3 to 2.0 dL/g, more preferably 0.5 to 1.5 dL/g, from the viewpoint of facilitating film formation. The intrinsic viscosity (η) of polyamic acid is the average value from measuring three times by using an Ubbelohde viscosity tube at 25°C when the polyamic acid is dissolved in N-methyl-2-pyrrolidone (NMP) so that the concentration of the polyamic acid becomes 0.5 g/dL.

The intrinsic viscosity (η) of the polyamic acid can be adjusted by the molar ratio (b/a) of the diamine (b mol) and the tetracarboxylic dianhydride (a mol), which constitute the polyamic acid.

A polyimide obtained by imidizing the polyamic acid varnish has high heat resistance (Tg, Tas) and re-solubility, and further, preferably has a high mechanical property (elongation percentage).

### 1-2. Additional component

A polyamic acid varnish of the present disclosure preferably further contains a solvent.

The solvent may be a solvent used for preparing the polyamic acid, and is not limited as long as the solvent can dissolve the diamine component and tetracarboxylic dianhydride component described above. For example, an aprotic polar solvent or an alcoholic solvent can be used.

Examples of the aprotic polar solvent include N-methyl-2-pyrrolidone, N,N-dimethylformamide, N,N-dimethylacetamide, dimethyl sulfoxide, hexamethylphosphoramide, 1,3-dimethyl-2-imidazolidinone, and ether compounds, such as 2-methoxyethanol, 2-ethoxyethanol, 2-(methoxymethoxy)ethoxyethanol, 2-isopropoxyethanol, 2-butoxyethanol, tetrahydrofurfuryl alcohol, diethylene glycol, diethylene glycol monomethyl ether, diethylene glycol monoethyl ether, diethylene glycol monobutyl ether, triethylene glycol, triethylene glycol monoethyl ether, tetraethylene glycol, 1-methoxy-2-propanol, 1-ethoxy-2-propanol, dipropylene glycol, dipropylene glycol monomethyl ether, dipropylene glycol monoethyl ether, tripropylene glycol monomethyl ether, polyethylene glycol, polypropylene glycol, tetrahydrofuran, dioxane, 1,2-dimethoxyethane, diethylene glycol dimethyl ether, and diethylene glycol diethyl ether.

Examples of the alcoholic solvent include methanol, ethanol, 1-propanol, 2-propanol, tert-butyl alcohol, ethylene glycol, 1,2-propanediol, 1,3-propanediol, 1,3-butanediol, 1,4-butanediol, 2,3-butanediol, 1,5-pentanediol, 2-butene-1,4-diol, 2-methyl-2,4-pentanediol, 1,2,6-hexanetriol, and diacetone alcohol.

These solvents may be used individually or in combination. In particular, N,N-dimethylacetamide, N-methyl-2-pyrrolidone, and mixed solvents thereof are preferred.

The concentration of resin solid content in the polyamic acid varnish is preferably 5 to 50 wt%, more preferably 10 to 30 wt%, from the viewpoint of improving coatability.

### 1-3. Method for producing polyamic acid varnish

A polyamic acid varnish can be obtained by adding a tetracarboxylic dianhydride and a diamine in a solvent and reacting the components. The types of solvent, tetracarboxylic dianhydride, and diamine to be used and the quantitative ratios therebetween are as described above.

The reaction for obtaining the polyamic acid varnish is preferably performed by heating the tetracarboxylic dianhydride and diamine in a solvent at a relatively low temperature (a temperature at which imidization does not occur). Specifically, the temperature at which imidization does not occur may be 5 to 120°C, preferably 25 to 80°C. In addition, the reaction is preferably performed in an environment substantially free of imidization catalysts (for example, triethylamine).

### 1-4. Physical properties of polyamic acid varnish

As described above, the polyamic acid varnish of the present disclosure allows provision of a polyimide having high heat resistance and re-solubility and further, preferably having a high mechanical property (elongation percentage).

### (1) Heat resistance

### (Glass transition temperature (Tg))

The glass transition temperature of a polyimide film obtained by imidizing the polyamic acid varnish is preferably 80°C or more and less than 260°C, more preferably 110 to 190°C. A polyimide having a glass transition temperature within the above range has satisfactory heat resistance and is therefore suitable as an adhesive used for, for example, electronic circuit boards and semiconductor devices.

The glass transition temperature of a polyimide may be measured by the following method. A polyimide film obtained by imidizing a polyamic acid varnish is cut into samples with a size of 5 mm in width and 22 mm in length. The glass transition temperature (Tg) of the obtained sample is measured with a thermal analyzer (for example, TMA-60, manufactured by Shimadzu Corporation). Specifically, the value of glass transition temperature (Tg) is obtained as follows: a TMA curve is obtained by performing measurement in the atmosphere at a temperature increase rate of 5°C/min and tensile mode (100 mN), and the curves before and after the inflection point derived from glass transition in the TMA curve are extrapolated.

### (5% Weight loss temperature (Tas))

From the same viewpoint as above, the 5% weight loss temperature (Tas) of the polyimide film, which is obtained by imidizing a polyamic acid varnish, in the atmosphere is preferably 400°C or higher, and more preferably 450°C or higher, and even more preferably 460°C or higher. The upper limit of T_{d5} of the polyimide is not limited, but may be, for example, 600°C.

The Tg and Tas of the polyimide film can be adjusted by the composition of the polyamic acid. For example, when the content of the tetracarboxylic dianhydride (A1) and the aromatic monomer (particularly the aromatic tetracarboxylic dianhydride having a biphenyl skeleton) is increased in the monomers constituting the polyamic acid, the Tg and Tas of the obtained polyimide are more likely to become high.

### (2) Re-solubility

For using as an adhesive, for example, a polyimide film obtained by imidizing a polyamic acid varnish preferably has high solubility (re-solubility) in a solvent from the viewpoint of dissolving the film in a solvent to easily peel the film off. Specifically, the dissolution ratio represented by the equation below is preferably 50% or more, more preferably 85% or more. The dissolution ratio is measured by immersing a polyimide film, which is obtained by imidizing a polyamic acid varnish, in N-methyl-2-pyrrolidone at 80°C for 3 minutes and then filtering the solution through filter paper. Dissolution ratio (%) = [1 - [(Weight of filter paper after filtration and drying) - (Weight of filter paper before use)]/(Weight of film before immersion)] × 100

Re-solubility can be measured by the following procedure.
1) A polyimide film obtained by imidizing the above-described polyamic acid varnish is cut into samples having a thickness of 20 µm and a size of 2.0 cm × 2.0 cm, and the weight of the sample (the weight of the film before dipping) is measured in advance. The imidization conditions are as follows: a temperature increase rate in the temperature range of 50 to 250°C in the atmosphere is set to preferably 0.25 to 30°C/min, more preferably 1 to 20°C/min, and even more preferably 2 to 10°C/min, and heating is performed for 30 minutes in a temperature range of 50 to 250°C. The weight of the filter paper before use is also measured.
2) The sample is then added to N-methyl-2-pyrrolidone (NMP) so that the concentration of the sample becomes 1 mass% to prepare a sample solution, and the obtained sample solution is left standing in an oven heated at 80°C for 3 minutes. Thereafter, the sample liquid is taken out of the oven, filtered through the filter paper, and then dried under reduced pressure at 100°C. The weight of the filter paper after filtration and drying is then measured.
3) The dissolution ratio is calculated by applying the measured values in the above items 1) and 2) to the above equation. These operations (operations of the above items 1) to 3)) are performed twice (n=2), and the average value is used as the dissolution ratio (%).

The size (such as thickness) of the sample is preferably the size described above, but a slightly different size is also possible.

The re-solubility of a polyimide film can be adjusted by the composition of the polyamic acid and the type of molecular end group. For example, when the content of the monomer (A) (particularly tetracarboxylic dianhydride (A1)) as a monomer constituting the polyamic acid is increased, the re-solubility of the obtained polyimide is more likely to increase. In addition, when the molecular end group of the polyamic acid is an acid anhydride group, the re-solubility of the obtained polyimide is more likely to increase.

### (3) Mechanical property (elongation percentage)

The elongation percentage of a polyimide film (obtained by imidizing a polyamic acid varnish) having a thickness of 20 µm at 23°C is preferably 65% or more, more preferably 85% or more, and even more preferably 100% or more.

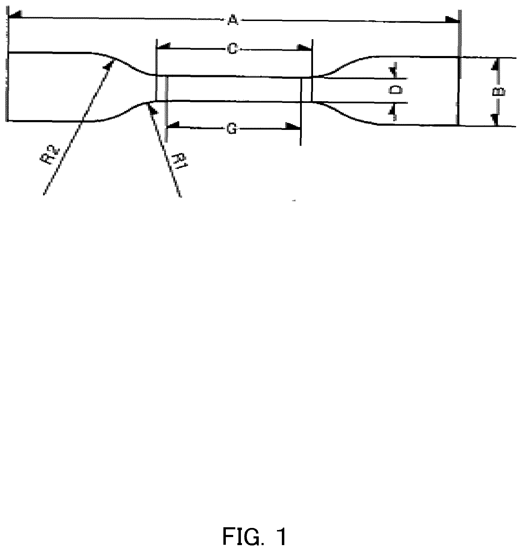

The elongation percentage of a polyimide film can be measured by the following method. FIG. 1 schematically illustrates a test piece to be used in a tensile fracture test.
1) First, a polyimide film is cut out to have a dumbbell shape as illustrated in FIG. 1 to obtain a sample film with the following size: A: 50 mm, B: 10 mm, C: 20 mm, and D: 5 mm.
2) The sample film is then placed in a tensile tester (for example, EZ-S, manufactured by Shimadzu Corporation) and pulled in the length direction (direction of A) at 23°C at a speed of 5 mm/min and a distance between chucks of 30 mm. The "elongation percentage at the time of tensile fracture" can be determined from the equation: (Length of sample film at the time of fracture - Original length of sample film) / (Original length of sample film) × 100 (%).

The elongation percentage of the polyimide film can be adjusted by the composition of the polyimide. For example, when the content of the aliphatic diamine (A2), which is the monomer (A) constituting the polyamic acid, is increased, or when the content of aromatic diamine (B2), having a diphenyl ether skeleton, as an aromatic monomer is increased, the elongation percentage of the obtained polyimide is more likely to increase.

### 2. Polyimide Composition

A polyimide composition of the present disclosure contains a polyimide obtained by imidizing the above-described polyamic acid. Such a polyimide composition may be obtained by heating the above-described polyamic acid varnish to imidize the polyamic acid varnish.

The temperature at which an polyamic acid is imidized may be, for example, 150 to 250°C. Therefore, when the temperature of a coating film is rapidly raised to 250°C or higher, the polyamic acid on the surface of the coating film is imidized before the solvent evaporates from the coating film. As a result, the solvent remaining in the coating film causes bubbles or unevenness on the surface of the coating film. Therefore, in the temperature range of 50 to 250°C, the temperature of the coating film is preferably gradually increased. Specifically, the temperature increase rate in the temperature range of 50 to 250 °C is preferably 0.25 to 30°C/min, more preferably 1 to 20°C/min, even more preferably 2 to 10°C/min.

The polyimide composition of the present disclosure may have any form, which may be a film, pellets, or powder.

A polyimide film made of the polyimide composition of the present disclosure (that is, a polyimide film having the thickness at the time of use) may also satisfy the above-described physical properties.

### 3. Applications of Polyimide Composition

As described above, the polyimide composition of the present disclosure has high heat resistance and re-solubility; thus, the polyimide composition can be used in applications that require these properties, for example, as adhesives, sealing materials, insulating materials, board materials, and protective materials for electronic circuit board components, semiconductor devices, surge parts, and the like.

That is, a laminate including a base material and a resin layer that contains the polyimide composition of the present disclosure and is disposed on the base material is possible. The material constituting the base material depends on the application and may be silicon, ceramics, metal, resin, or the like. Examples of the metal include copper, aluminum, SUS, iron, magnesium, nickel, and alumina. Examples of the ceramics include silicon carbide, gallium nitride, and gallium oxide. Examples of the resin include urethane resin, epoxy resin, acrylic resin, polyimide, PET resin, polyamide, and polyamideimide. The base material preferably contains at least one element selected from the group consisting of Si, Ga, Ge, As, and AI. The base material is more preferably a semiconductor substrate containing at least one element selected from the group consisting of Si, Ga, Ge, As, and AI. The base material is particularly preferably a semiconductor substrate containing at least one member selected from the group consisting of silicon, silicon carbide, gallium nitride, gallium oxide, and sapphire.

The laminate may be produced, for example, by applying the polyamic acid varnish of the present disclosure onto a base material, and then heating and imidizing the varnish to form a resin layer made of a polyimide composition. As described above, the heating temperature of the coating film may be set to a temperature suitable for the imidization.

### Electronic circuit board component

The polyimide composition of the present disclosure may be used as an insulating substrate or an adhesive on a circuit board, particularly on a flexible circuit board. For example, a flexible circuit board may include metal foil (base material) and an insulating layer made of the polyimide composition of the present disclosure (obtained from the polyamic acid varnish of the present disclosure) disposed thereon. Alternatively, a flexible circuit board may include an insulating resin film (base material), an adhesive layer made of the polyimide composition of the present disclosure, and metal foil.

### Semiconductor component

The polyimide composition of the present disclosure may be used as an adhesive for bonding semiconductor chips to each other or for bonding a semiconductor chip to a substrate, a protective material for protecting a circuit of a semiconductor chip, an embedding material (sealing material) for embedding a semiconductor chip, and the like.

That is, the semiconductor component of the present disclosure includes a semiconductor chip (base material) and a resin layer made of the polyimide composition of the present disclosure (obtained from the polyamic acid varnish of the present disclosure) and disposed on at least one surface of the semiconductor chip. Examples of the semiconductor chip include diodes, transistors, integrated circuits (ICs), and power devices. The resin layer made of a polyimide composition may be disposed on the surface of the semiconductor chip on which terminals are formed (terminal formation surface), or may be disposed on a surface different from the surface on which terminals are formed.

The thickness of the layer made of the polyimide composition is preferably about 1 to 100 µm when, for example, the polyimide composition is used as an adhesive layer. When the polyimide composition layer is used as a circuit protection layer, the thickness is preferably about 2 to 200 µm.

### Adhesive for surge part

The polyimide composition of the present disclosure may be used as an adhesive or a sealing material for surge parts (surge absorbers) to protect home appliances, computers, transportation equipment such as automobiles, mobile devices, power supplies, servers, telephones, and the like against abnormal currents and voltages that affect these products. By using the polyimide composition of the present disclosure as an adhesive or a sealing material, it is possible to bond or seal surge parts at low temperatures, and satisfactory voltage resistance and heat resistance can be achieved.

Among the above applications, the polyimide composition of the present disclosure preferably used as an adhesive for electronic circuit board components, semiconductor components, surge parts, and the like. The polyimide composition is particularly preferably used as an adhesive for semiconductor components, an adhesive for flexible printed circuit boards, an adhesive for coverlay films, or an adhesive for bonding sheets.

That is, an electronic device such as an electronic circuit board or a semiconductor component may be produced, for example, by the following steps: after applying the polyamic acid varnish of the present disclosure on a base material, imidizing the varnish to form a resin layer (adhesive) of a polyimide composition; disposing an electronic part on the resin layer and bonding the electronic part to the resin layer; and dissolving the resin layer in a solvent to peel the electronic part from the base material. Alternatively, the electronic device may be produced by the following steps: preparing a laminate including a base material, a resin layer, and a handling substrate; processing the base material; and dissolving the resin layer in a solvent to peel the processed base material (processed product) from the handling board. The laminate can be obtained, for example, by applying the polyamic acid varnish of the present disclosure to one of the base material and the handling substrate, and then imidizing the polyamic acid varnish to form a layer containing the polyimide composition, and then bonding the other one of the base material and the handling substrate.

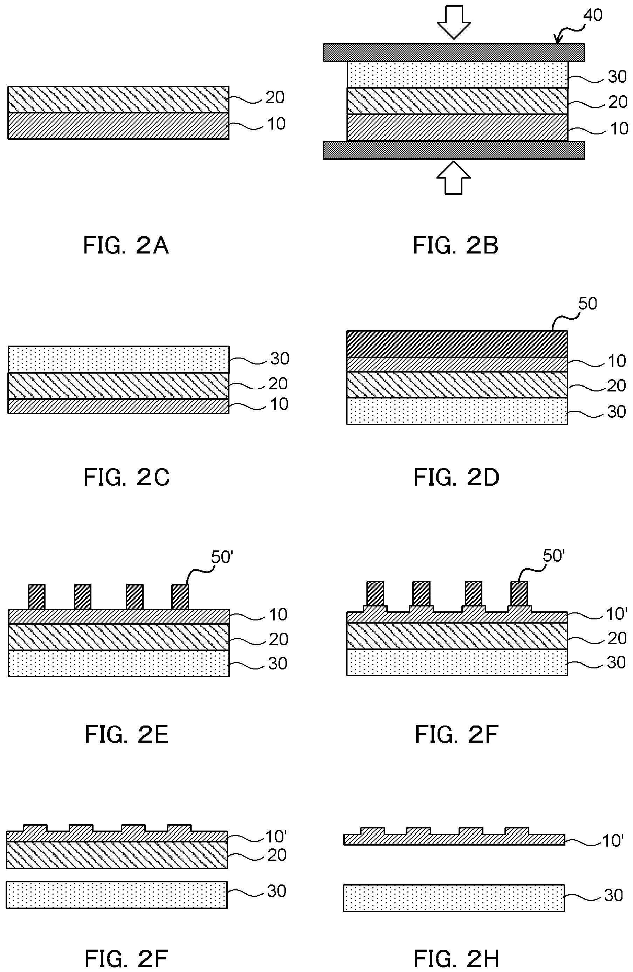

FIGS. 2A to 2H are schematic cross-sectional views illustrating an exemplary process of processing of a silicon substrate by using the polyimide composition of the present disclosure as a temporary fixing adhesive. As illustrated in FIGS. 2A to 2H, a polyamic acid varnish of the present disclosure is applied onto, for example, silicon substrate 10 (base material), and then the composition is heated and imidized to form resin layer 20 containing the polyimide resin composition (see FIG. 2A). Handling substrate 30 (for example, a glass substrate) is then placed on resin layer 20 and the components are subjected to thermocompression bonding by using heat press machine 40 to obtain a laminate (see FIG. 2B). The back surface of silicon substrate 10 is then polished until the substrate has a predetermined thickness (see FIG. 2C). Resist 50 is then placed on the polished silicon substrate 10, and resist pattern 50' is formed (see FIG. 2E), and silicon substrate 10 is etched and patterned along resist pattern 50' (see FIG. 2F). Handling substrate 30 is then peeled off from resin layer 20 by laser or mechanical processing (see FIG. 2G). The patterned silicon substrate 10' thus can be obtained by dissolving resin layer 20 in a solvent and peeling the substrate off (see FIG. 2H). In this process, for example, in the step of polishing the back surface of silicon substrate 10 (see FIG. 2C) and the step of etching and heat-treating silicon substrate 10 (see FIG. 2F), a high temperature of 200°C or higher is applied.

In the manufacturing process of electronic circuit boards, semiconductor components, and the like, after processing a base material fixed onto a handling substrate via a resin layer (the processing including, for example, heating steps such as polishing step, etching/heat-treating step, and electrode film formation/rewiring steps), the base material may be peeled off from the substrate together with the adhesive without leaving any adhesive residue. The polyimide composition of the present disclosure (obtained from the polyamic acid varnish of the present disclosure) has heat resistance to withstand a heating step and can be dissolved in a solvent or the like; therefore, the polyimide composition can be peeled off without leaving any adhesive residue. Therefore, the polyimide composition of the present disclosure is suitable as an adhesive for electronic circuit boards, semiconductor components, and the like, and are particularly suitable as a temporary fixing adhesive (adhesive that is used for bonding and then peeled off).

### Examples

Hereinafter, the present disclosure will be described in more detail with reference to Examples. However, the scope of the present disclosure is not limited thereto. Acid anhydrides and diamines used in Examples and Comparative Examples are described below.

### (1) Acid dianhydride

1) Tetracarboxylic acid anhydride (A1)
   Compound represented by the following Formula (BSPA8: 5,5'-(octane-1,8-diyl)bis(isobenzofuran-1,3-dione)) 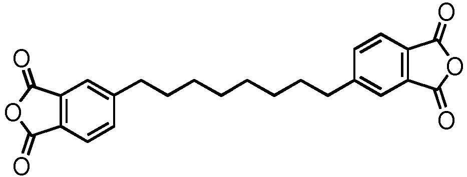
2) Aromatic tetracarboxylic acid anhydride (B1)
   - Aromatic tetracarboxylic dianhydride having biphenyl skeleton s-BPDA: 3,3',4,4'-biphenyltetracarboxylic dianhydride
   - Aromatic tetracarboxylic dianhydride having diphenyl ether skeleton ODPA: 4,4'-oxydiphthalic anhydride
   - Aromatic tetracarboxylic dianhydride having benzophenone skeleton BTDA: 3,3',4,4'-benzophenonetetracarboxylic dianhydride
   - Aromatic tetracarboxylic dianhydride having hexafluoroisopropylidene skeleton 6FDA: 4,4'-(hexafluoroisopropylidene)diphthalic dianhydride
   - Aromatic tetracarboxylic dianhydride having fluorene skeleton
      BPAF: 9,9-bis(3,4-dicarboxyphenyl)fluorene dianhydride

### (2) Diamine

1) Aliphatic diamine (A2)
   1,6-Diaminohexane
   1,12-Diaminododecane
2) Aromatic diamine (B2)
   - Aromatic diamine having diphenyl ether skeleton
      p-BAPP: 2,2-bis(4-(4-aminophenoxy)phenyl)propane
      APB-N: 1,3-bis(3-aminophenoxy)benzene (manufactured by Mitsui Chemicals, Inc.)
   - Elasmer 1000P: Polyetherdiamine (refer to the following Formula, amine value 80 to 90, Mw = 1268, manufactured by Ihara Chemical Industry Co., Ltd.) 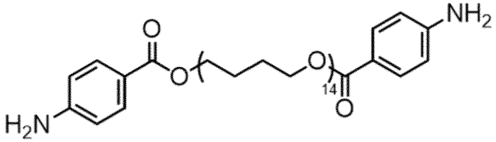
3) Additional diamine
   RT1000: Polyetheramine (refer to the following Formula, Mw=1015, manufactured by HUNTSMAN) 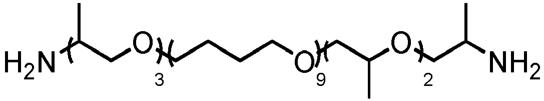
   DACH: 1,2-cyclohexanediamine
   14-BAC: 1,4-bisaminomethylcyclohexane
   D230: Polyoxypropylene diamine (Mw = 230, manufactured by Mitsui Fine Chemicals, Inc.)
   D2000: Polyoxypropylene diamine (Mw=2000, manufactured by Mitsui Fine Chemicals, Inc.)

### (Examples 1 to 13 and Comparative Examples 1 to 6)

### Preparation of polyamic acid varnish

Acid dianhydrides and diamines of the types and amounts shown in Table 1 were added into a solvent prepared with NMP (N-methylpyrrolidone). The resulting mixture was stirred at 65°C for 5 hours or more in a flask that allows introduction of dry nitrogen gas, thereby obtaining a polyamic acid varnish having a resin solid content of 20 to 25 mass%.

### Production of film

The obtained polyamic acid varnish was applied on a glass plate at a speed of 10 mm/sec, and then the temperature was raised from 50°C to a predetermined temperature (180 to 250°C) at a rate of 5°C/min, followed by heating at the predetermined temperature for 30 minutes to imidize the varnish while removing the solvent. The obtained polyimide film was peeled from the glass plate to obtain a polyimide film (polyimide composition) having a thickness of 20 µm.

### (Evaluation)

Intrinsic viscosity (1) of the polyamic acid each prepared in Examples 1 to 13 and Comparative Examples 1 to 6 was measured by the following method. In addition, each obtained polyimide film was evaluated for re-solubility (2), heat resistance (3), and elongation percentage (4) by using the following methods.

### (1) Intrinsic viscosity η

A solution, in which each obtained polyamic acid varnish was diluted with NMP so that the concentration of the polyamic acid became 0.5 g/dL, was measured three times at 25°C in accordance with JIS K7367-1:2002 by using an Ubbelohde viscosity tube (size number 1), and the average value was used as the intrinsic viscosity η.

### (2) Re-solubility

1) Each obtained polyimide film was cut into samples having a size of 2.0 cm × 2.0 cm, and the weight of the sample (the weight of the film before dipping) was measured in advance. The weight of the filter paper before use was also measured.
2) The sample was then added to N-methyl-2-pyrrolidone (at an amount such that the concentration of the sample becomes 1 mass%, 5 to 7 mL in this case) to prepare a sample solution, and the obtained sample solution was left standing in an oven heated at 80°C for 3 minutes. Thereafter, the sample liquid is taken out of the oven, filtered through filter paper (mesh size: 5B), and then dried under reduced pressure at 100°C. The weight of the filter paper after filtration and drying was then measured.
3) The dissolution ratio was calculated by applying the measured values in the above items 1) and 2) to the following equation. These operations (operations of the above items 1) to 3)) were performed twice (n=2), and the average value was used as the dissolution ratio (%).
Dissolution ratio (%) = [1 - [(Weight of filter paper after filtration and drying) - (Weight of filter paper before use)] / (Weight of film before immersion)] × 100

The operation was performed twice (n=2), and the average value was employed. A dissolution ratio of 50% or more was determined to be satisfactory, and a dissolution ratio of 85% or more was determined to be particularly satisfactory.

### (3) Thermophysical property

### (Glass transition temperature (Tg))

Each obtained polyimide film was cut into samples with a size of 5 mm in width and 22 mm in length. The glass transition temperature (Tg) of the obtained sample was measured with a thermal analyzer (TMA-60), manufactured by Shimadzu Corporation. Specifically, the value of glass transition temperature (Tg) was obtained as follows: a TMA curve was obtained by performing measurement in the atmosphere at a temperature increase rate of 5°C/min and tensile mode (100 mN), and the curves before and after the inflection point derived from glass transition in the TMA curve were extrapolated.

### (5% Weight loss temperature (Tas))

The 5% weight loss temperature (Tas) of each obtained polyimide film was measured with a thermogravimetric analyzer (TGA-60), manufactured by Shimadzu Corporation. Specifically, the obtained polyimide film (approximately 5 mg) was accurately weighed on the analyzer, the scanning temperature was set at 30 to 900°C, and the temperature increase rate was set at 10°C/min while air gas was allowed to flow at 50 mL/min in the atmosphere. The T_{d5} was defined as a temperature at which the mass of the sample decreased by 5%.

A T_{d5} of 400°C or higher was determined to be satisfactory.

### (4) Mechanical property

### (Elongation percentage)

Each obtained polyimide film was cut out to have a dumbbell shape as illustrated in FIG. 1 to obtain a sample film with the following size: A: 50 mm, B: 10 mm, C: 20 mm, and D: 5 mm.

The obtained sample film was placed in a tensile tester EZ-S (manufactured by Shimadzu Corporation) and pulled in the length direction (direction of A) at 23°C at a speed of 5 mm/min and a distance between chucks of 30 mm. The "elongation percentage at the time of tensile fracture" was defined from the equation: (Length of sample film at the time of fracture - Original length of sample film) / (Original length of sample film) × 100 (%).

An elongation percentage of 65% or more was determined to be satisfactory.

Table 1 shows the evaluation results of Examples 1 to 10, and Table 2 shows the evaluation results of Examples 11 to 13 and Comparative Examples 1 to 6. The molar ratio of diamine and tetracarboxylic dianhydride is calculated from the charged amount (mol) of diamine and the charged amount (mol) of tetracarboxylic dianhydride.

**Table 1**

| | Diamine (mol) | | Dianhydride (mol) | | Diamine/ Dianhydride | Monomer (A) (mol%) | Proportion of aromatic monomer in monomer (B) (mol%) | Varnish | Re-solubility | | Thermophysical property | | Mechanical property |
|---|---|---|---|---|---|---|---|---|---|---|---|---|---|
| | First component | Second component | First component | Second component | | | | Intrinsic viscosity η (dL/g) | Visual evaluation | Dissolution ratio (%) | Tg (°C) | Td5 (°C) | Elongation (%) |
| Ex. 1 | pBAPP 0.97 | | BSPA8 1 | | 0.97 | 50.8 | 100 | 0.53 | ○ | >90 | 142 | 460 | 96 |
| Ex. 2 | pBAPP 0.97 | | sBPDA 0.2 | BSPA8 0.8 | 0.97 | 40.6 | 100 | 0.78 | ○ | >90 | 158 | 464 | 106 |
| Ex. 3 | pBAPP 0.97 | | sBPDA 0.5 | BSPA8 0.5 | 0.97 | 25.4 | 100 | 0.91 | ○ | >90 | 187 | 477 | 88 |
| Ex. 4 | APB-N 0.97 | | sBPDA 0.2 | BSPA8 0.8 | 0.97 | 40.6 | 100 | 0.53 | ○ | >90 | 116 | 457 | 118 |
| Ex. 5 | pBAPP 0.97 | | ODPA 0.2 | BSPA8 0.8 | 0.97 | 40.6 | 100 | 1.13 | ○ | >90 | 157 | 458 | 68 |
| Ex. 6 | pB APP 0.97 | | BTDA 0.2 | BSPA8 0.8 | 0.97 | 40.6 | 100 | 1.21 | ○ | >90 | 156 | 463 | 82 |
| Ex. 7 | pBAPP 0.97 | | BPAF 0.2 | BSPA8 0.8 | 0.97 | 40.6 | 100 | 1.13 | ○ | >90 | 161 | 463 | 73 |
| Ex. 8 | pBAPP 0.97 | | 6FDA 0.2 | BSPA8 0.8 | 0.97 | 40.6 | 100 | 1.21 | ○ | >90 | 172 | 462 | 82 |
| Ex. 9 | pBAPP 0.87 | DACH 0.1 | sBPDA 0.2 | BSPA8 0.8 | 0.97 | 40.6 | 91.5 | 1.14 | ○ | >90 | 161 | 458 | 73 |
| Ex. 10 | pBAPP 0.87 | 1,4-BAC 0.1 | sBPDA 0.2 | BSPA8 0.8 | 0.97 | 40.6 | 91.5 | 0.77 | ○ | >90 | 157 | 461 | 93 |

| | | | | | | | | | | | | | |
|---|---|---|---|---|---|---|---|---|---|---|---|---|---|
| ∘: Satisfactory | | | | | | | | | | | | | |

**Table 2**

| | Diamine (mol) | | Dianhydride (mol) | | Diamine /Dianhydride | Monomer (A) (mol%) | Proportion of aromatic monomer in monomer (B) (mol%) | Varnish | Re-solubility | | Thermophysical property | | Mechanical property |
|---|---|---|---|---|---|---|---|---|---|---|---|---|---|
| | First component | Second component | First component | Second component | | | | Intrinsic viscosity η (dL/g) | Visual evaluation | Dissolution ratio (%) | Tg (°C) | Td5 (°C) | Elongation (%) |
| Ex. 11 | pBAPP 0.194 | C6 Diamine 0.776 | sBPDA 0.5 | BSPA8 0.5 | 0.97 | 64.8 | 100 | 0.63 | ○ | >90 | 115 | 447 | 104 |
| Ex. 12 | pBAPP 0.194 | C12 Diamine 0.776 | sBPDA 0.5 | BSPA8 0.5 | 0.97 | 64.8 | 100 | 0.49 | ○ | >90 | 80 | 415 | 122 |
| Ex. 13 | pBAPP 1 | | sBPDA 0.194 | BSPA8 0.776 | 1.03 | 39.4 | 100 | 1.47 | ○ | 58 | 165 | 464 | 67 |
| Comp. Ex. 1 | pBAPP 0.97 | | sBPDA 0.8 | BSPA8 0.2 | 0.97 | 10.2 | 100 | 0.97 | × | 39 | 223 | 485 | 66 |
| Comp. Ex. 2 | pBAPP 0.97 | | sBPDA 1 | | 0.97 | 0 | 100 | 0.79 | × | 35 | 248 | 503 | 62 |
| Comp. Ex. 3 | pBAPP 0.706 | RT1000 0.274 | sBPDA 0.5 | ODPA 0.5 | 0.98 | 0 | 86.2 | 0.88 | ○ | >90 | 116 | 330 | 180 |
| Comp. Ex. 4 | pBAPP 0.706 | 1000P 0.274 | sBPDA 0.5 | ODPA 0.5 | 0.98 | 0 | 100 | 0.54 | ○ | >90 | 123 | 342 | 154 |
| Comp. Ex. 5 | pBAPP 0.706 | D230 0.274 | sBPDA 0.5 | ODPA 0.5 | 0.98 | 0 | 86.2 | 0.57 | ○ | >90 | 184 | 372 | 58 |
| Comp. Ex. 6 | pBAPP 0.706 | D2000 0.274 | sBPDA 0.5 | ODPA 0.5 | 0.98 | 0 | 86.2 | 0.74 | ○ | >90 | 125 | 201 | 190 |

| | | | | | | | | | | | | | |
|---|---|---|---|---|---|---|---|---|---|---|---|---|---|
| ○: Satisfactory, ×: Unsatisfactory | | | | | | | | | | | | | |

Table 1 shows that the polyimide films obtained from the polyamic acid varnishes of Examples 1 to 13 each containing a component derived from the monomer (A) have satisfactory re-solubility while high heat resistance (Tas) of 400°C or higher and satisfactory elongation percentage are achieved.

In particular, the tables show that by setting the molar ratio of diamine/acid dianhydride to less than 1 (acid anhydride group at the molecular end), the re-solubility of the film is further improved (comparison between Examples 2 and 13).

The tables also show that polyimide films obtained from the polyamic acid varnishes of Comparative Example 1, in which the component derived from the monomer (A) is less than 15 mol%, and of Comparative Examples 2 to 6, which do not contain the monomer (A), have low re-solubility or low heat resistance (Tas).

This application is entitled to and claims the benefit of Japanese Patent Application No. 2021-175481 filed on October 27, 2021, the disclosure of which including the specification and drawings is incorporated herein by reference in its entirety.

### Industrial Applicability

A polyamic acid varnish of the present disclosure allows provision of a polyimide having high heat resistance and re-solubility. Therefore, the obtained polyimide is suitable as an adhesive for various fields where high heat resistance and re-solubility are required, for example, as an adhesive for electronic circuit board components, semiconductor devices, and the like.

## Claims

1. A polyamic acid varnish comprising a polyamic acid, wherein:
a monomer constituting the polyamic acid contains
a monomer (A) that has a linear alkylene group having 4 to 12 carbon atoms and has no ester bond, amide bond, and ether bond, and
a monomer (B) other than the monomer (A);
a content of the monomer (A) is 15 to 70 mol% based on a total amount of the monomer constituting the polyamic acid; and
the monomer (B) contains 90 mol% or more of an aromatic monomer.

2. The polyamic acid varnish according to claim 1, wherein:
the monomer (A) contains a tetracarboxylic dianhydride (A1) having an aromatic ring; and
the aromatic ring is directly bonded with the linear alkylene group and with an acid anhydride group of the tetracarboxylic dianhydride (A1).

3. The polyamic acid varnish according to claim 2, wherein
the tetracarboxylic dianhydride (A1) is a compound represented by Formula (1) below 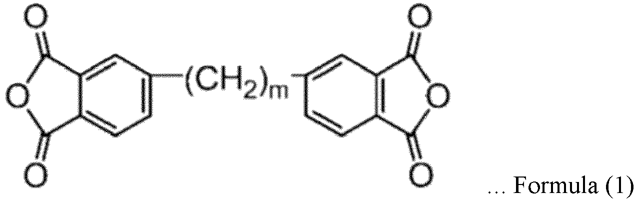
wherein m is an integer from 4 to 12.

4. The polyamic acid varnish according to claim 1, wherein
the aromatic monomer contains
at least one aromatic tetracarboxylic dianhydride (B1) selected from the group consisting of an aromatic tetracarboxylic dianhydride having a biphenyl skeleton, an aromatic tetracarboxylic dianhydride having a diphenyl ether skeleton, an aromatic tetracarboxylic dianhydride having a benzophenone skeleton, an aromatic tetracarboxylic dianhydride having a hexafluoroisopropylidene skeleton, and an aromatic tetracarboxylic dianhydride having a fluorene skeleton.

5. The polyamic acid varnish according to claim 4, wherein
the polyamic acid varnish contains 10 mol% or more of the aromatic tetracarboxylic dianhydride having the biphenyl skeleton based on a total amount of a tetracarboxylic dianhydride constituting the polyamic acid.

6. The polyamic acid varnish according to claim 1, wherein
the aromatic monomer contains an aromatic diamine (B2) having a diphenyl ether skeleton.

7. The polyamic acid varnish according to claim 6, wherein
the aromatic diamine (B2) having the diphenyl ether skeleton has three or more aromatic rings.

8. The polyamic acid varnish according to claim 6, wherein
the aromatic diamine (B2) having the diphenyl ether skeleton is represented by Formula (2) below 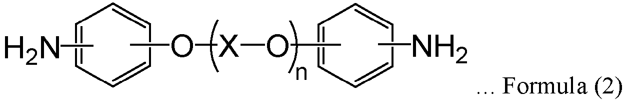
wherein, in Formula (2),
X represents an arylene group having 6 to 10 carbon atoms or a group represented by Formula (α) below, and
n is an integer from 1 to 3 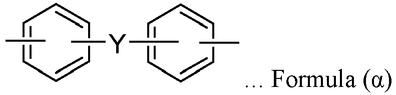
wherein, in Formula (α),
Y represents a divalent group selected from the group consisting of oxygen atom, sulfur atom, sulfone group, methylene group, fluorene structure, -CR¹R²- (R¹ and R² are each a substituted or unsubstituted alkyl group having 1 to 3 carbon atoms or a phenyl group), and
R¹ and R² are optionally bonded with each other to form a ring.

9. The polyamic acid varnish according to claim 6, wherein
the aromatic diamine (B2) having the diphenyl ether skeleton contains at least one member selected from the group consisting of 1,3-bis(3-aminophenoxy)benzene, 1,3-bis(4-aminophenoxy)benzene, and 2,2-bis[4-(4-aminophenoxy)phenyl]propane.

10. The polyamic acid varnish according to any one of claims 1 to 9, wherein
a molar ratio between a diamine and a tetracarboxylic dianhydride both constituting the polyamic acid is 0.9 to 0.999, the molar ratio being represented by diamine / tetracarboxylic dianhydride.

11. The polyamic acid varnish according to any one of claims 1 to 9, wherein
a dissolution ratio represented by an equation below is 50% or more dissolution ratio (%) = [1 - [(weight of filter paper after filtration and drying) - (weight of filter papart before use)] / (weight of film before immersion)] × 100
the dissolution ratio being measured after immersing a polyimide film having a size of 2.0 cm × 2.0 cm and a thickness of 20 µm in N-methyl-2-pyrrolidone at 80°C for 3 minutes and then performing filtering through filter paper, the polyimide film being obtained by imidizing the polyamic acid varnish.

12. The polyamic acid varnish according to any one of claims 1 to 9, wherein
a 5% weight loss temperature of a polyimide film in an atmosphere is 400°C or higher, the polyimide film being obtained by imidizing the polyamic acid varnish.

13. The polyamic acid varnish according to any one of claims 1 to 9, wherein
an elongation percentage at 23°C of a polyimide film having a thickness of 20 µm is 65% or more, the polyimide film being obtained by imidizing the polyamic acid varnish.

14. A polyimide composition comprising a polyimide, wherein:
a monomer constituting the polyimide contains
a monomer (A) that has a linear alkylene group having 4 to 12 carbon atoms and has no ester bond, amide bond, and ether bond, and
a monomer (B) other than the monomer (A);
a content of the monomer (A) is 15 to 70 mol% based on a total amount of the monomer constituting the polyimide; and
the monomer (B) contains 90 mol% or more of an aromatic monomer.

15. An adhesive, comprising:
the polyimide composition according to claim 14.

16. The adhesive according to claim 15, wherein
the adhesive is an adhesive for a semiconductor component, an adhesive for a flexible printed circuit board, an adhesive for a coverlay film, or an adhesive for a bonding sheet.
